# EUROPÄISCHE PATENTANMELDUNG

(11) **EP 0 978 868 A1**
(43) Veröffentlichungstag der Anmeldung: **09.02.2000**
(21) Anmeldenummer: 99810632.2
(22) Anmeldetag: 14.07.1999
(51) Int. Cl.: H01L 21/266, H01L 21/322, H01L 29/32

(54) **Verfahren zur Einstellung der Trägerlebensdauer in einem Halbleiterbauelement**

(30) Priorität: 06.08.1998 DE 19835528
(71) Anmelder: Asea Brown Boveri AG, 5401 Baden (CH)
(72) Erfinder: Galster, Norbert, 5102 Rupperswil (CH); Hazdra, Pavel, Dr., 16000 Prag 6 (CZ); Vobecky, Jan, Dr., 16000 Prag 6 (CZ)
(74) Vertreter: Clerc, Natalia

(57) **Zusammenfassung**

In einem Verfahren zur Einstellung der Trägerlebensdauer in einem Halbleiterbauelement (1) mittels Partikelbestrahlung (P) werden im Halbleiterbauelement (1) mindestens zwei Defektstellenzonen (10,11,12,13) erzeugt. Ein Partikelstrahl (P), bestehend aus Teilchen (a,b,c,d) mit mindestens annähernd derselben Ausgangsenergie, wird dabei vor Auftreffen auf das Halbleiterbauelement (1) durch mindestens ein Mittel (2) derart beeinflusst, dass die Teilchen (a,b,c,d) anschliessend unterschiedliche Energiewerte aufweisen, wobei mindestens zwei Energiewertgruppen unterscheidbar sind. Es lassen sich somit mit einer einzigen Partikelbestrahlung eine beliebige Anzahl Defektstellenzonen erzeugen, deren Anordnung und Gewichtung beliebig wählbar ist.

## Beschreibung

### TECHNISCHES GEBIET

Die vorliegende Erfindung bezieht sich auf das Gebiet der Leistungselektronik. Sie betrifft ein Verfahren zur Einstellung der Trägerlebensdauer in einem Halbleiterbauelement gemäss Oberbegriff des Patentanspruches 1 sowie ein Mittel zur Durchführung des Verfahrens gemäss Oberbegriff des Patentanspruches 7.

### STAND DER TECHNIK

Das dynamische Verhalten eines Halbleiterbauelementes wird wesentlich durch dessen Trägerlebensdauer beeinflusst. Durch Einstellung der Trägerlebensdauer lassen sich beispielsweise Durchlassverluste regeln, Sperrverhalten optimieren und Abschaltcharakteristika verbessern. Die Trägerlebensdauer wird durch Erzeugung von Defektstellen im Halbleiterbauelement eingestellt. Derartige Defektstellen lassen sich grundsätzlich auf drei Arten schaffen: durch Bestrahlung mit Elektronen, durch Dotierung mit Schwermetallen, insbesondere mit Platin oder Gold, oder durch Partikelbestrahlung mit energiereichen, schweren Teilchen oder Ionen, beispielsweise mit Protonen oder Heliumkernen.

Die Bestrahlung mit Elektronen führt dazu, dass die Defektstellen im gesamten Volumen des Halbleitersubstrates erzeugt werden. Bei der Dotierung oder der Partikelbestrahlung hingegen wird das Halbleiterbauelement lediglich in einer begrenzten Zone mit Defektstellen versehen, wobei das restliche Element praktisch unbeeinflusst bleibt. Dies erlaubt eine gezieltere Einstellung der Trägerlebensdauer. Da Dotierungsverfahren jedoch relativ aufwendig sind, hat sich mittlerweile die Partikelbestrahlung als Technologie zur Einstellung der Trägerlebensdauer etabliert.

Bei dieser Partikelbestrahlung wird ein Teilchenstrahl auf eine Oberfläche des Halbleiterbauelementes gerichtet, so dass die Teilchen in das Halbleitermaterial eindringen und dort Defektstellen erzeugen. Die Dichte der Defekte entlang der Trajektorie der Teilchen ist zunächst gering und steigt kurz vor erreichen der maximalen Eindringtiefe steil an. In diesem Bereich liegt somit die Mehrzahl der Defekte. Die entsprechende "mittlere" Eindringtiefe der Teilchen hängt dabei von deren Energie und der Beschaffenheit der zu durchdringenden Materie ab. Durch Wahl der Teilchenenergie ist es möglich, deren Eindringtiefe vorauszubestimmen und somit die Lage der Defektstellenzone genau einzustellen. Da alle Teilchen des Partikelstrahls dieselbe Energie aufweisen, wird mit einer einmaligen Partikelbestrahlung eine einzige Defektstellenzone gebildet.

Bei vielen Anwendungen reicht jedoch eine einzige Partikelbestrahlung nicht aus, um eine optimale Abschaltcharakeristik zu erhalten. Ist eine einzige örtlich relativ scharf begrenzte Defektstellenzone vorhanden, ändert sich der Stromwert im Abschaltvorgang abrupt, Ueberspannungen werden induziert und der Spannungswert beginnt zu oszillieren. Es hat sich jedoch gezeigt, dass eine Kombination einer Elektronenbestrahlung mit einer Partikelbestrahlung bereits zu einer Verbesserung führt.

Zudem ist aus Solid State Electronics, Vol. 36, No. 2, pp. 133-141, 1993, bekannt, dass sich das Abschaltverhalten eines GTO Thyristors (Gate-Turn-Off) verbessern lässt, wenn in verschiedenen Eindringtiefen Defektstellenzonen vorhanden sind. Hierfür wird der GTO mehrere Male mit Teilchen bestrahlt, wobei die einzelnen Bestrahlungen mit unterschiedlichen Energiewerten durchgeführt werden. Dieses Verfahren führt zwar zu guten Ergebnissen. Mehrfachbestrahlungen sind jedoch teuer und erhöhen die Produktionszeiten.

### DARSTELLUNG DER ERFINDUNG

Es ist deshalb Aufgabe der vorliegenden Erfindung, ein Verfahren zur Einstellung der Trägerlebensdauer in einem Halbleiterbauelement und ein Mittel zur Durchführung des Verfahrens der eingangs genannten Art zu schaffen, welche die obengenannten Nachteile beheben.

Diese Aufgabe löst ein Verfahren mit den Merkmalen des Patentanspruches 1 sowie ein Mittel zur Durchführung des Verfahrens mit den Merkmalen des Patentanspruches 7.
Weitere vorteilhafte Varianten des Verfahrens und vorteilhafte Ausgestaltungsformen gehen aus den abhängigen Patentansprüchen hervor.

Im erfindungsgemässen Verfahren wird ein Halbleiterbauelement mit einem Partikelstrahl bestrahlt, welcher sich aus Teilchen mit unterschiedlicher kinetischer Energie zusammensetzt. Dadurch lassen sich mit einer einzigen Partikelbestrahlung eine beliebige Anzahl Defektstellenzonen im Halbleiterbauelement erzeugen, deren Verteilung und Gewichtung zudem beliebig wählbar ist.

Hierfür wird der Partikelstrahl vor Auftreffen auf das Halbleiterbauelement derart beeinflusst, dass seine Teilchen, welche beim Verlassen der Strahlungsquelle alle mindestens annähernd dieselbe Ausgangsenergie aufwiesen, nunmehr unterschiedliche Energiewerte besitzen, wobei mindestens zwei Energiewertgruppen unterscheidbar sind und wobei die einer Energiegruppe zugehörigen Teilchen mindestens annähernd dieselbe Energie aufweisen. Die Anzahl der Gruppen korreliert dabei mit der Anzahl zu erzeugender Defektstellenzonen.

Der Partikelstrahl lässt sich auf relativ einfache Art und Weise mit Hilfe mindestens einer Maske beeinflussen, indem mindestens ein Teil des Partikelstrahls diese durchdringt. Durch spezielle Gestaltung der Maske, insbesondere durch Materialwahl und Strukturgebung, lässt sich jede gewünschte Anzahl Energiegruppen mit beliebigem prozentualen Anteil Teilchen und somit jede gewünschte axiale Verteilung von Defektstellenzonen im Halbleiterbauelement erzielen. Es lassen sich insbesondere zwei, drei, vier oder mehr Defektstellenzonen erzeugen. Ferner können die einzelnen Defektstellenzonen voneinander isoliert sein oder sich gegenseitig teilweise überlappen.

Werden mehrere Masken im Strahlengang angeordnet, so lassen sich komplizierte Verteilungen und Formen von Defekstellenzonen mit einfach geformten Maskentypen erzielen.

Der Partikelstrahl wird im allgemeinen beim Durchdringen der Maske gestreut, so dass jede Energiegruppe austretender Teilchen ein Energieband mit einer streuungsbedingten Bandbreite definiert. Die erhaltenen Defektstellenzonen sind dadurch breiter als bei einer Mehrfachbestrahlung. Diese Verbreiterung der Defektstellenprofile wirkt sich wiederum positiv auf das Verhalten des Halbleiterbauelementes aus, insbesondere auf seine Abschaltcharakteristik.

Durch einen geeigneten Abstand der Maske vom Target oder durch Scannen des Targets bzw. von Ionenstrahl und Maske wird eine lateral homogene Bestrahlung erreicht. Befindet sich eine Maske während der Bestrahlung bezüglich des Halbleiterbauelementes in Ruhe und überdeckt sie dieses nur teilweise, so lässt sich zudem eine laterale Defektzonenverteilung erzielen.

Das erfindungsgemässe Verfahren lässt sich bei allen bekannten Halbleiterbauelementen zur Einstellung der Trägerlebensdauer einsetzen. Es eignet sich insbesondere zur Herstellung von Halbleiterdioden.

### KURZE ERLÄUTERUNG DER FIGUREN

Anhand der beiliegenden schematischen Zeichnungen wird das erfindungsgemässe Verfahren näher erläutert. Es zeigen
- Figur 1: eine Darstellung einer Partikelbestrahlung mit einer ersten Maske;
- Figur 2: die Maske gemäss Figur 1 von oben;
- Figur 3: das mit der Bestrahlung gemäss Figur 1 erzeugte Defektstellenprofil;
- Figur 4: eine Darstellung einer Partikelbestrahlung mit einer zweiten Maske;
- Figur 5: die Maske gemäss Figur 4 von oben;
- Figur 6: das mit der Bestrahlung gemäss Figur 4 erzeugte Defektstellenprofil und
- Figur 7: eine Darstellung einer Partikelbestrahlung gemäss einer dritten Variante des Verfahrens.

### WEGE ZUR AUSFÜHRUNG DER ERFINDUNG

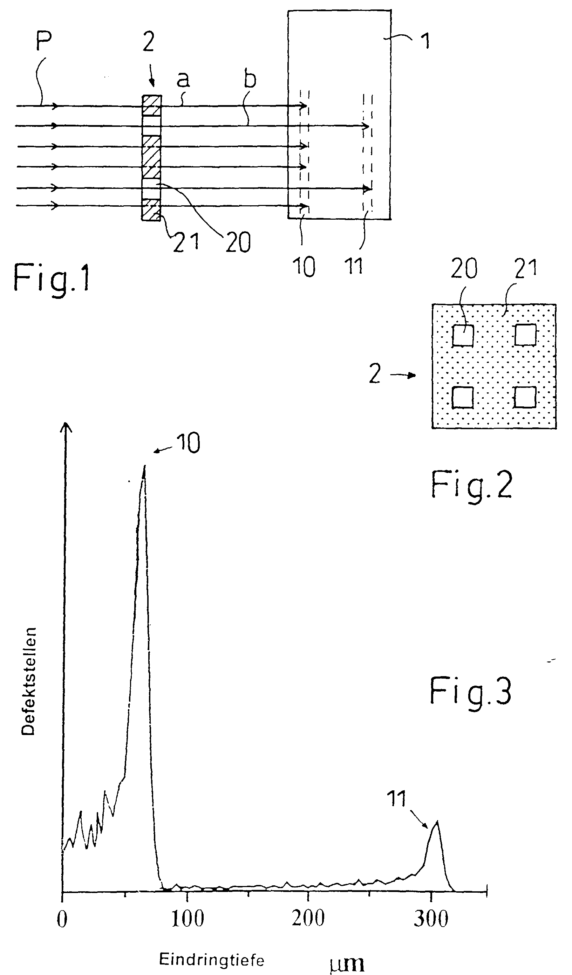

In den Figuren 1 bis 3 ist eine erste Variante des erfindungsgemässen Verfahrens dargestellt. Ein Halbleiterbauelement 1 wird mit einem Partikelstrahl P bestrahlt. Die hier dargestellte Bestrahlung erfolgt anodenseitig, wie dies beispielsweise für Leistungs-Halbleiterdioden durchgeführt wird. Die Richtung der Bestrahlung ist jedoch für die vorliegende Erfindung nicht wesentlich, sondern hängt vom jeweilig zu bestrahlenden Halbleiterbauelement ab. Deckt, wie hier dargestellt, der Partikelstrahl P im Vergleich zum Halbleiterbauelement 1 eine kleinere Fläche ab, so wird das Halbleiterbauelement 1 während der Bestrahlung verschoben, damit sukzessiv seine gesamte Fläche dem Teilchenbeschuss ausgesetzt wird.

Im Strahlengang des Partikelstrahls P ist eine Maske 2 angeordnet. Diese kann, wie hier dargestellt ist, die gesamte Fläche des Strahlenganges abdecken. In einer anderen Ausführungsform beeinflusst sie ihn nur teilweise. Die Distanz zwischen Maske 2 und Oberfläche des Halbleiterbauelementes 1 ist keine zwingend wesentliche Grösse. Durch Wahl oder Variation der Distanz lässt sich jedoch die Bestrahlungsdichte wählen, da sich der Partikelstrahl mit zunehmendem Abstand von der Maske im allgemeinen immer mehr aufweitet.

Die Maske 2 lässt sich aus den verschiedensten Materialien fertigen, vorzugsweise wird hierfür jedoch ein Metall oder Kunststoff verwendet. Bevorzugte Materialien sind Silizium, Aluminium, Nickel oder Platin. Die Dicke der Maske hängt von der zu erzielenden Bremswirkung ab, typische Werte liegen zwischen 10 - 300 µm. Es lassen sich die unterschiedlichsten Formen von Masken verwenden. Die in Figur 2 dargestellte Maske 2 weist ein Lochraster mit Löchern 20 auf. Dabei sind lediglich vier Löcher dargestellt, stellvertretend für die Vielzahl der tatsächlich vorhandenen. Das Verhältnis von Löcher 20 zu geschlossener Fläche 21 wird dabei in Abhängigkeit der zu erzielenden Defektstellenprofile gewählt. Es liegt normalerweise zwischen 1:1 bis 1:20 und beträgt vorzugsweise mindestens annähernd 1:6. Auch die Grösse der Löcher 20 wird auf das zu erzielende Ergebnis abgestimmt. Typische Werte betragen 0.5 - 1 mm².

Wie in Figur 1 dargestellt ist, durchdringt der Partikelstrahl P die Maske 2, bevor er auf das Halbleiterbauelement 1 auftrifft. Vor dem Auftreffen auf die Maske 2 besitzen alle seine Teilchen mindestens annähernd dieselbe Ausgangsenergie Eo. Erste Teilchen a, welche durch die geschlossene Fläche 21 der Maske 2 dringen, werden gebremst. Ihre kinetische Energie E₁ beim Verlassen der Maske 2 ist kleiner als die Ausgangsenergie Eo. Zweite Teilchen b jedoch, welche die Löcher 20 passieren, werden nicht beeinflusst und weisen nach wie vor die Ausgangsenergie E₀ auf.

Treffen die Teilchen auf das Halbleiterbauelement 1 auf, so dringen die höherenergetischen zweiten Teilchen b tiefer ein als die niederenergetischen. Die ersten Teilchen a erzeugen dabei eine erste Defektstellenzone 10 und die zweiten Teilchen b eine zweite Defektstellenzone 11. Dabei liegt die erste Defektstellenzone 10 näher an der bestrahlungsseitigen Oberfläche als die zweite. Dies ist aus den Figuren 1 und 3 ersichtlich. Ein erster Peak, gemäss Figur 3, bei einer Eindringtiefe von annähernd 70 µm entspricht dabei der ersten Defektstellenzone 10. Der Peak ist wesentlich grösser als ein Peak der zweiten Defektstellenzone 11 bei einer Eindringtiefe von circa 300 µm, da aufgrund der Gestaltung der Maske mehr Teilchen abgebremst worden sind als ungehindert passieren konnten. Wie in Figur 3 dargestellt, befindet sich diese zweite Defektstellenzone 11 nahe an der kathodenseitigen Oberfläche, wenn man von einer gesamten Dicke des Halbleiterbauelementes von 350 µm ausgeht. Diese Anordnung ist insbesondere für Halbleiterdioden vorteilhaft.

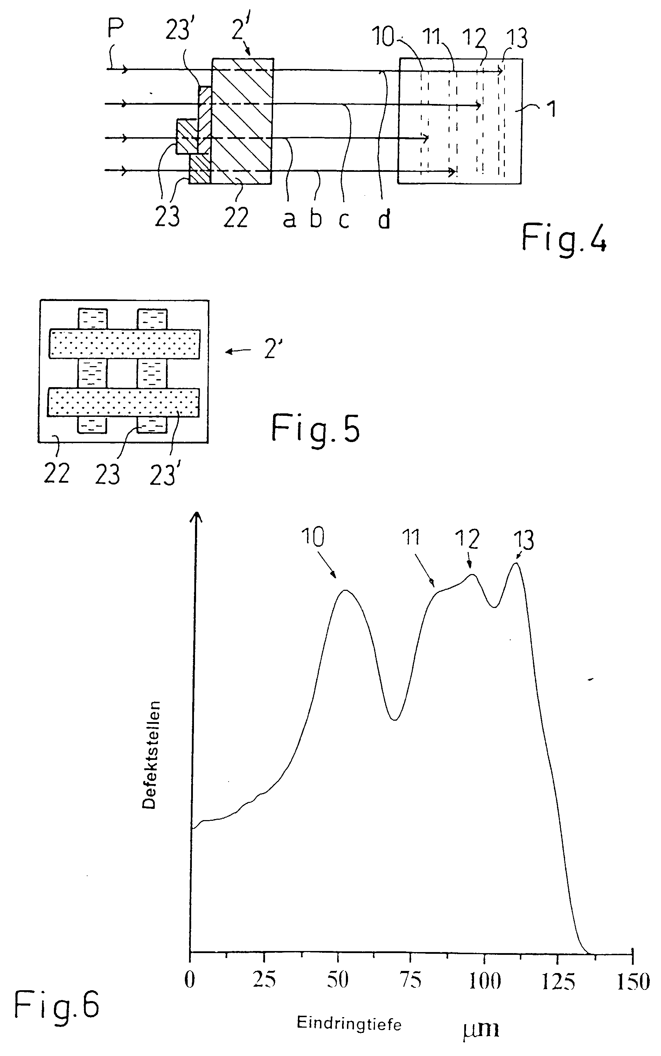

In den Figuren 4 bis 6 ist eine zweite Variante des erfindungsgemässen Verfahrens dargestellt. Es wird ein Halbleiterbauelement geschaffen, welches nach einer einmaligen Partikelbestrahlung über vier Peaks beziehungsweise Defektstellenzonen 10,11,12,13 verfügt. Es hat sich gezeigt, dass eine Erhöhung der Defektstellenzonen das Abschaltverhalten verbessert. Die verwendete Maske 2' ist in den Figuren 4 und 5 dargestellt. Sie besteht aus verschiedenen Materialien, nämlich aus einer Basis 22 aus einem ersten Material, beispielweise Silizium, auf welcher eine oder mehrere Schichten 23, 23' aus weiteren Materialien, beispielsweise Platin, aufgebracht sind. Löcher sind in diesem Beispiel jedoch keine vorhanden. Figur 4 zeigt dabei lediglich den schematischen Aufbau der Maske 2' und entspricht nicht einem Querschnitt durch die Maske 2' gemäss Figur 5.

Die Teilchen des Partikelstrahls P durchdringen somit unterschiedliche Durchlassbereiche, welche untereinander in Dicke und Materialzusammensetzung variieren. Die hier dargestellte Anordnung weist vier derartiger Durchlassbereiche auf, so dass der Partikelstrahl P nach Verlassen der Maske 2' im wesentlichen Teilchen a,b,c,d mit vier unterschiedlichen Energiewerten aufweist, welche im Halbleiterbauelement vier Defektstellenzonen 10-13 erzeugen.

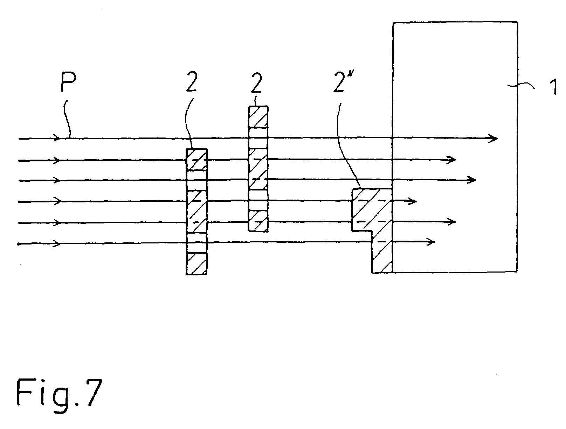

In Figur 7 ist eine dritte Anordnung zur Durchführung des erfindungsgemässen Verfahrens dargestellt. Hier sind mehrere Masken 2, genauer zwei, hintereinander angeordnet. Die Masken können, wie hier dargestellt ist, identisch sein, wobei ihre Durchlassbereiche zueinander versetzt im Strahlengang angeordnet sind. Dies hat den Vorteil, dass lediglich ein einziger und relativ einfacher Maskentyp gefertigt werden muss. Es ist jedoch auch möglich, verschieden geformte Masken hintereinander anzuordnen. Ferner ist eine dritte Maske 2" vorhanden, welche lagestabil bezüglich des Halbleiterbauelementes 1 angeordnet ist. In diesem Beispiel ist sie deshalb direkt auf dem Halbleiterbauelement 1 angebracht. Diese dritte Maske 2" erlaubt eine laterale Variation des Defektstellenprofils.

### BEZEICHNUNGSLISTE

- 1: Halbleiterbauelement
- 10: erste Defektstellenzone
- 11: zweite Defektstellenzone
- 12: dritte Defektstellenzone
- 13: vierte Defektstellenzone
- 2,2', 2": Maske
- 20: Loch
- 21: geschlossene Fläche
- 22: Basis
- 23,23': Schicht
- P: Partikelstrahl
- a,b,c,d: Teilchen

## Patentansprüche

1. Verfahren zur Einstellung der Trägerlebensdauer in einem Halbleiterbauelement (1) mittels Partikelbestrahlung (P), wobei im Halbleiterbauelement (1) mindestens zwei Defektstellenzonen (10,11,12,13) erzeugt werden,
dadurch gekennzeichnet, dass
ein Partikelstrahl (P), bestehend aus Teilchen (a,b,c,d) mit mindestens annähernd derselben Ausgangsenergie, vor Auftreffen auf das Halbleiterbauelement (1) durch mindestens ein Mittel (2) derart beeinflusst wird, dass die Teilchen (a,b,c,d) anschliessend unterschiedliche Energiewerte aufweisen, wobei mindestens zwei Energiewertgruppen unterscheidbar sind.

2. Verfahren nach Anspruch 1, dadurch gekennzeichnet, dass mindestens ein Teil des Partikelstrahls (P) vor Auftreffen auf das Halbleiterbauelement (1) mindestens eine Maske (2) durchdringt.

3. Verfahren nach Anspruch 2, dadurch gekennzeichnet, dass das Halbleiterbauelement (1) relativ zur Maske (2) bewegt wird.

4. Verfahren nach Anspruch 1, dadurch gekennzeichnet, dass eine einzige Partikelbestrahlung (P) durchgeführt wird.

5. Verfahren nach Anspruch 2, dadurch gekennzeichnet, dass der gesamte Partikelstrahl (P) die mindestens eine Maske (2) durchdringt.

6. Verfahren nach Anspruch 1, dadurch gekennzeichnet, dass der Partikelstrahl (P) mindestens eine Maske (2) durchdringt, welche lagestabil relativ zum Halbleiterbauelement (1) angeordnet ist.

7. Mittel zur Beeinflussung eines Partikelstrahls (P) zur Durchführung des Verfahrens gemäss Anspruch 1, dadurch gekennzeichnet, dass es eine Maske (2) ist, welche sie durchdringende Teilchen (a,b,c,d) des Partikelstrahls (P) bremst.

8. Mittel gemäss Anspruch 7, dadurch gekennzeichnet, dass die Maske (2) in mindestens zwei Bereiche (20,21) unterteilt ist, welche sich voneinander unterscheidende Bremswirkungen auf sie durchdringende Teilchen (a,b,c,d) ausüben.

9. Mittel nach Anspruch 8, dadurch gekennzeichnet, dass die Bereiche (20,21) verschiedene Dicken aufweisen.

10. Mittel nach Anspruch 8, dadurch gekennzeichnet, dass die Maske (2) Löcher (20) aufweist.

11. Mittel nach Anspruch 7, dadurch gekennzeichnet, dass es aus Metall und/oder Kunststoff gefertigt ist.
